# EUROPEAN PATENT APPLICATION

(11) **EP 3 979 417 A1**
(43) Date of publication of application: **06.04.2022**
(21) Application number: 20834218.8
(22) Date of filing: 09.06.2020
(51) Int. Cl.: H01Q 1/42

(54) **HOUSING ASSEMBLY, ANTENNA APPARATUS, AND ELECTRONIC DEVICE**

(30) Priority: 30.06.2019 CN 201910582091
(71) Applicant: GUANGDONG OPPO MOBILE TELECOMMUNICATIONS CORP., LTD., Wusha, Chang'an Dongguan Guangdong 523860 (CN)
(72) Inventor: JIA, Yuhu, Dongguan, Guangdong 523860 (CN)
(74) Representative: Mewburn Ellis LLP
(86) International application number: PCT/CN2020/095214
(87) International publication number: WO 2021/000704

(57) **Abstract**

A housing assembly, an antenna device, and an electronic device are provided. The housing assembly includes a dielectric substrate, an impedance matching layer, and a coupling structure. The dielectric substrate has a first transmittance to a radio frequency (RF) signal in a preset frequency band. The impedance matching layer is stacked with the dielectric substrate and is used for spatial impedance matching of the RF signal in the preset frequency band. The coupling structure is stacked with the dielectric substrate and includes one or more array layers of coupling elements, where the array layer has resonance characteristics in the preset frequency band. The housing assembly has a second transmittance to the RF signal in the preset frequency band in a region corresponding to the coupling structure, and the second transmittance is greater than the first transmittance. According to implementations of this application, a transmittance of the housing assembly to the RF signal can be improved.

## Description

### TECHNICAL FIELD

This disclosure relates to the technical field of electronics, and more particularly to a housing assembly, an antenna device, and an electronic device.

### BACKGROUND

Millimeter waves have characteristics of high carrier frequency and large bandwidth and can achieve the ultra-high data transmission rate of the fifth generation (5G). Because millimeter wave antennas are sensitive to the environment, for a millimeter wave antenna array in the entire device, a structure covered above the antenna array needs to be optimized, to achieve better radiation performance of a system.

### SUMMARY

Implementations of this application provide a housing assembly. The housing assembly includes a dielectric substrate, an impedance matching layer, and a coupling structure. The dielectric substrate has a first transmittance to a radio frequency (RF) signal in a preset frequency band. The impedance matching layer is stacked with the dielectric substrate and is used for spatial impedance matching of the RF signal in the preset frequency band. The coupling structure is stacked with the dielectric substrate and includes one or more array layers of coupling elements, where the array layer has resonance characteristics in the preset frequency band. The housing assembly has a second transmittance to the RF signal in the preset frequency band in a region corresponding to the coupling structure, and the second transmittance is greater than the first transmittance.

Implementations of this application further provide an antenna device. The antenna device includes an antenna module and the housing assembly of any of the above implementations. The antenna module is spaced apart from the coupling structure and is disposed at one side of the coupling structure away from the dielectric substrate. The coupling structure is at least partially located within a preset direction range in which the antenna module emits and receives an RF signal. The coupling structure is used to match a frequency of the RF signal, to improve a transmittance to the RF signal. The impedance matching layer is used for spatial impedance matching of the RF signal, to increase a bandwidth of the RF signal.

Implementations of this application further provide an electronic device. The electronic device includes a mainboard, an antenna module, and the housing assembly of any of the above implementations. The mainboard is received in the housing assembly. The mainboard defines an accommodating space at one side of the housing assembly facing the coupling structure and the antenna module is received in the accommodating space and electrically coupled to the mainboard. The antenna module includes at least one antenna radiator and the antenna radiator is configured to, under control of the mainboard, emit and receive RF signals which pass through the housing assembly.

### BRIEF DESCRIPTION OF THE DRAWINGS

To describe technical solutions in implementations of this application more clearly, the following briefly introduces the accompanying drawings required for describing the implementations. Apparently, the accompanying drawings in the following description only illustrate some implementations of this application. Those of ordinary skill in the art may also obtain other drawings based on these accompanying drawings without creative efforts.
FIG. 1 is a schematic structural diagram of a side view of a housing assembly provided in implementations of this application.
FIG. 2 is a schematic structural diagram of a front view of a housing assembly provided in implementations of this application.
FIG. 3 is a schematic structural diagram of a front view of a housing assembly provided in other implementations of this application.
FIG. 4 is a schematic structural diagram of a front view of a housing assembly provided in other implementations of this application.
FIG. 5 is a schematic structural diagram of a front view of a housing assembly provided in other implementations of this application.
FIG. 6 is a schematic structural diagram of a front view of a housing assembly provided in other implementations of this application.
FIG. 7 is a schematic structural diagram of a front view of a housing assembly provided in other implementations of this application.
FIG. 8 is a schematic structural diagram of a front view of a housing assembly provided in other implementations of this application.
FIG. 9 is a schematic structural view of a first array layer of the housing assembly of FIG. 8.
FIG. 10 is a schematic structural view of a second array layer of the housing assembly of FIG. 8.
FIG.11 is a schematic structural view of an antenna device provided in implementations of this application.
FIG. 12 is a schematic structural view of an antenna module provided in implementations of this application.
FIG. 13 is a schematic structural view of a top view of an antenna module provided in implementations of this application.
FIG. 14 is a schematic structural view of an antenna module provided in other implementations of this application.
FIG. 15 is a schematic structural view of an antenna module provided in other implementations of this application.
FIG. 16 is a schematic structural view of a top view of an antenna module provided in other implementations of this application.
FIG. 17 is a schematic structural view of an antenna module provided in other implementations of this application.
FIG. 18 is a schematic structural view of an antenna module provided in other implementations of this application.
FIG. 19 is a schematic structural view of a top view of a feed ground layer of FIG. 18.
FIG. 20 is a schematic structural view of an electronic device provided in implementations of this application.
FIG. 21 is a schematic structural view of an electronic device provided in other implementations of this application.
FIG. 22 is a schematic structural view of an electronic device provided in other implementations of this application.
FIG. 23 is a schematic structural view of an electronic device provided in other implementations of this application.
FIG. 24 is a schematic structural view of an electronic device provided in other implementations of this application.
FIG. 25 is a schematic diagram of curves of a reflection coefficient and a transmission coefficient of a 2×2 antenna module under a glass battery cover.
FIG. 26 is a schematic diagram of a curve of a reflection coefficient of a 2×2 antenna module under a housing assembly.
FIG. 27 is a schematic diagram of a curve of a transmission coefficient of a 2×2 antenna module under a housing assembly.

### DETAILED DESCRIPTION

Technical solutions in the implementations of this application will be described clearly and completely hereinafter with reference to the accompanying drawings in the implementations of this application. Apparently, the described implementations are merely some rather than all implementations of this application. All other implementations obtained by those of ordinary skill in the art based on the implementations of this application without creative efforts shall fall within the protection scope of this application.

Implementations of this application provide a housing assembly. The housing assembly includes a dielectric substrate, an impedance matching layer, and a coupling structure. The dielectric substrate has a first transmittance to a radio frequency (RF) signal in a preset frequency band. The impedance matching layer is stacked with the dielectric substrate and is used for spatial impedance matching of the RF signal in the preset frequency band. The coupling structure is stacked with the dielectric substrate and includes one or more array layers of coupling elements, where the array layer has resonance characteristics in the preset frequency band. The housing assembly has a second transmittance to the RF signal in the preset frequency band in a region corresponding to the coupling structure, and the second transmittance is greater than the first transmittance.

In at least one implementation, the impedance matching layer is disposed at one side of the dielectric substrate and the coupling structure is disposed at one side of the impedance matching layer away from the dielectric substrate. Alternatively, coupling structure is disposed at one side of the dielectric substrate and the impedance matching layer is disposed at one side of the coupling structure away from the dielectric substrate.

In at least one implementation, the array layer further has dual-polarization resonance characteristics in the preset frequency band.

In at least one implementation, the coupling structure includes one array layer and the array layer is attached to one surface of the dielectric substrate, and the impedance matching layer is disposed at one side of the array layer away from the dielectric substrate and is used to encapsulate and protect the array layer.

In at least one implementation, the coupling structure includes one array layer. The impedance matching layer includes a first matching layer and a second matching layer. The first matching layer is disposed at one surface of the dielectric substrate. The array layer is disposed at one side of the first matching layer away from the dielectric substrate. The first matching layer is used to connect the array layer to the dielectric substrate. The second matching layer is disposed at one side of the array layer away from the first matching layer and is used to encapsulate and protect the array layer.

In at least one implementation, the coupling structure includes a first array layer and a second array layer spaced apart from the first array layer. The impedance matching layer includes a first matching layer and a second matching layer. The first array layer is disposed at one surface of the dielectric substrate. The first matching layer is disposed at one side of the first array layer away from the dielectric substrate. The first matching layer is used to connect the first array layer to the dielectric substrate and is used to encapsulate and protect the first array layer. The second array layer is disposed at one side of the first matching layer away from the first array layer. The second matching layer is disposed at one side of the second array layer away from the first matching layer and is used to encapsulate and protect the second array layer.

In at least one implementation, the coupling structure includes a first array layer and a second array layer spaced apart from the first array layer. The impedance matching layer includes a first matching layer, a second matching layer, and a third matching layer. The first matching layer is disposed at one surface of the dielectric substrate. The first array layer is disposed at one surface of the first matching layer away from the dielectric substrate. The second matching layer is disposed at one side of the first array layer away from the first matching layer. The second array layer is disposed at one side of the second matching layer away from the first array layer. The third matching layer is disposed at one side of the second array layer away from the second matching layer and is used to encapsulate and protect the second array layer.

In at least one implementation, the first array layer and the second array layer are each disposed at a respective one of two opposite sides of the second matching layer, and the first array layer is closer to the dielectric substrate than the second array layer.

In at least one implementation, a projection of the first array layer on the second matching layer and a projection of the second array layer on the second matching layer are at least partially non-overlapping.

In at least one implementation, the first array layer defines a through hole and a projection of the second array layer on the first array layer falls into the through hole.

In at least one implementation, the through hole is in a shape of circle, oval, square, triangle, rectangle, hexagon, ring, cross, or Jerusalem cross.

In at least one implementation, the first matching layer is an adhesive, the second matching layer is a bearing layer, and the third matching layer is an adhesive.

In at least one implementation, the first array layer is a square patch and has a side length of 1.6 mm. The second array layer is a square patch and has a side length of 1.05 mm. The through hole is a square hole and has a size of 1.3 mm×1.3 mm. The dielectric substrate has a thickness of 0.55 mm, the first matching layer has a thickness of 0.02 mm, the second matching layer has a thickness of 0.45 mm, and the third matching layer has a thickness of 0.03 mm.

In at least one implementation, the array layer includes multiple coupling elements arranged in an array, where the multiple coupling elements are made of conductive materials and have dual-frequency dual-polarization resonance characteristics in the preset frequency band.

In at least one implementation, the preset frequency band at least includes all frequency bands of millimeter wave of the 3rd generation partnership project (3GPP).

Implementations of this application further provide an antenna device. The antenna device includes an antenna module and the housing assembly of any of the above implementations. The antenna module is spaced apart from the coupling structure and is disposed at one side of the coupling structure away from the dielectric substrate. The coupling structure is at least partially located within a preset direction range in which the antenna module emits and receives an RF signal. The coupling structure is used to match a frequency of the RF signal, to improve a transmittance to the RF signal. The impedance matching layer is used for spatial impedance matching of the RF signal, to increase a bandwidth of the RF signal.

In at least one implementation, the antenna module includes multiple antenna radiators arranged in an array. The antenna radiator has a first feed point and a second feed point. The first feed point is configured to feed a first current signal to the antenna radiator and the first current signal is used to excite the antenna radiator to resonate in a first frequency band to emit and receive an RF signal in the first frequency band. The second feed point is configured to feed a second current signal to the antenna radiator and the second current signal is used to excite the antenna radiator to resonate in a second frequency band, where the first frequency band is different from the second frequency band.

In at least one implementation, the antenna device further includes a support plate, an RF chip, and an RF line, where the antenna radiator is disposed on a surface of the support plate adjacent to the coupling structure, the RF chip is disposed at one side of the support plate away from the coupling structure, and the RF line electrically couples the RF chip with the antenna radiator.

In at least one implementation, the support plate defines a limiting hole and the RF line is located in the limiting hole.

In at least one implementation, the support plate defines multiple metallized vias arranged around the antenna radiator to isolate two adjacent antenna radiators.

In at least one implementation, the antenna device further includes a support plate, an RF chip, a feed ground layer, and a feed line. The antenna radiator is disposed on a surface of the support plate adjacent to the coupling structure and the RF chip is disposed at one side of the support plate away from the coupling structure. The feed ground layer is located between the support plate and the RF chip and serves as a ground electrode of the antenna radiator. The feed line is disposed between the RF chip and the feed ground layer and is electrically coupled to the RF chip. The feed ground layer defines an aperture, a projection of the feed line on the feed ground layer at least partially falls into the aperture, and the feed line is configured to couple and feed the antenna radiator via the aperture.

In at least one implementation, a polarization direction of a resonance mode of the antenna radiator excited by the first current signal is different from a polarization direction of a resonance mode of the antenna radiator excited by the second current signal.

Implementations of this application further provide an electronic device. The electronic device includes a mainboard, an antenna module, and the housing assembly of any of the above implementations. The mainboard is received in the housing assembly. The mainboard defines an accommodating space at one side of the housing assembly facing the coupling structure and the antenna module is received in the accommodating space and electrically coupled to the mainboard. The antenna module includes at least one antenna radiator and the antenna radiator is configured to, under control of the mainboard, emit and receive RF signals which pass through the housing assembly.

In at least one implementation, the electronic device further includes a battery cover, where the battery cover acts as the dielectric substrate and is made of one or more of plastic, glass, sapphire, and ceramic.

In at least one implementation, the battery cover includes a rear plate and a side plate surrounding the rear plate, the side plate is located within a preset direction range in which the antenna radiator emits and receives RF signals, the coupling structure is disposed at one side of the side plate facing the antenna radiator, and the side plate acts as the dielectric substrate.

In at least one implementation, the battery cover includes a rear plate and a side plate surrounding the rear plate, the rear plate is located within a preset direction range in which the antenna radiator emits and receives RF signals, the coupling structure is disposed at one side of the rear plate facing the antenna radiator, and the rear plate acts as the dielectric substrate.

In at least one implementation, the electronic device further includes a screen, where the screen acts as the dielectric substrate.

In at least one implementation, the electronic device further includes a protective cover, where the protective cover is located within a preset direction range in which the antenna radiator emits and receives RF signals and the protective cover acts as the dielectric substrate.

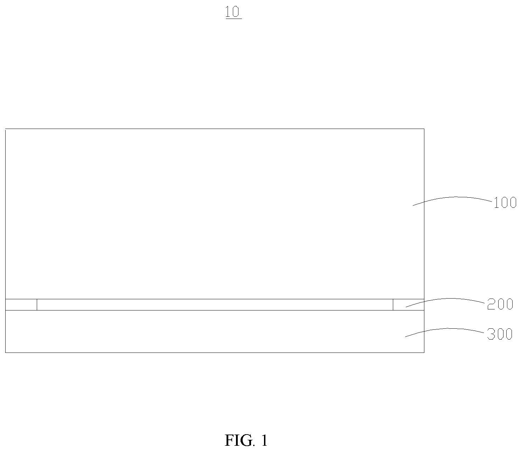

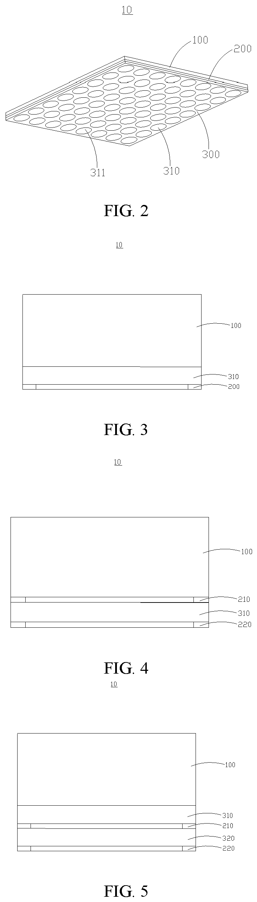

Referring to FIG.1 and FIG. 2, a housing assembly 10 is provided in implementations. The housing assembly 10 includes a dielectric substrate 100, an impedance matching layer 200, and a coupling structure 300. The dielectric substrate 100 has a first transmittance to an RF signal in a preset frequency band. The impedance matching layer 200 is stacked with the dielectric substrate 100 and is used for spatial impedance matching of the RF signal in the preset frequency band. The coupling structure 300 is stacked with the dielectric substrate 100 and includes one or more array layers 310 of coupling elements, where the array layer 310 has resonance characteristics in the preset frequency band. The housing assembly 10 has a second transmittance to the RF signal in the preset frequency band in a region corresponding to the coupling structure 300, and the second transmittance is greater than the first transmittance.

The RF signal can penetrate the dielectric substrate 100, the impedance matching layer 200, and the coupling structure 300. The RF signal can be a millimeter wave signal. The impedance matching layer 200 is used for spatial impedance matching of the RF signal. The dielectric substrate 100 has the first transmittance to the RF signal in the preset frequency band. The coupling structure 300 is located on one side of the dielectric substrate 100. The coupling structure 300 includes the one or more array layers 310 of coupling elements. The array layer 310 has resonance characteristics in the preset frequency band, which is used to make the RF signal resonate, so that the transmittance to the RF signal can be improved. As such, the housing assembly 10 has the second transmittance to the RF signal in the preset frequency band in the region corresponding to the coupling structure 300, and the second transmittance is greater than the first transmittance. In other words, due to the resonance characteristics of the array layer, the transmittance to the RF signal in the region of the housing assembly 10 corresponding to the coupling structure 300 can be improved. When the coupling structure 300 is within a radiation direction range of an antenna, a radiation gain of the antenna can be improved.

In at least one implementation, the array layer 310 further has dual-polarization resonance characteristics in the preset frequency band. Due to the dual-polarization resonance characteristics, for the RF signal, secondary resonance arises and the RF signal exhibits dual-polarization characteristics. The preset frequency band at least includes all frequency bands of millimeter wave of the 3rd generation partnership project (3GPP). According to the specification of the 3GPP TS 38.101, two frequency ranges: FR1 and FR2 are mainly used in 5G. The frequency range corresponding to FR1 is 450 MHz~6 GHz, also known as the sub-6 GHz; the frequency range corresponding to FR2 is 24.25 GHz~52.6 GHz, usually called millimeter wave (mm Wave). Currently, 3GPP (version 15) specifies the frequency bands of the 5G millimeter wave as follows: n257 (26.5-29.5 GHz), n258 (24.25-27.5 GHz), n261 (27.5-28.35 GHz), and n260 (37~40 GHz). Thus, the preset frequency band at least cover n257, n258, n261, and n260.

In at least one implementation, the array layer 310 includes multiple coupling elements 311 arranged in an array, where the multiple coupling elements 311 are made of conductive materials and have dual-frequency dual-polarization resonance characteristics in the preset frequency band.

The multiple coupling elements 311 can be made of metal. The multiple coupling elements 311 are arranged in an array, such that the RF signal in the preset frequency band have dual-frequency dual-polarization resonance characteristics. That is, the RF signal can have multiple operating frequency bands and multiple radiation directions.

According to the housing assembly 10 of the implementations, the impedance matching layer 200 is disposed at one side of the dielectric substrate 100 and is used for spatial impedance matching of the RF signal in the preset frequency band, to increase a bandwidth of the RF signal. Furthermore, the coupling structure 300 is disposed at one side of the dielectric substrate 100 and includes the array layer 310 having resonance characteristics in the preset frequency band, such that a transmittance of the housing assembly 10 to the RF signal in the region corresponding to the coupling structure 300 is higher than a transmittance of the dielectric substrate 100 to the RF signal, thereby improving the transmittance to the RF signal.

In at least one implementation, the impedance matching layer 200 is disposed at one side of the dielectric substrate 100 and the coupling structure 300 is disposed at one side of the impedance matching layer 200 away from the dielectric substrate 100; or the coupling structure 300 is disposed at one side of the dielectric substrate 100 and the impedance matching layer 200 is disposed at one side of the coupling structure 300 away from the dielectric substrate 100.

In an implementation manner, the housing assembly 10 includes the coupling structure 300, the impedance matching layer 200, and the dielectric substrate 100 that are sequentially stacked. The impedance matching layer 200 can be served as a support layer and an adhesion layer, for example used to support the coupling structure 300 and to bond the coupling structure 300 to the dielectric substrate 100. The impedance matching layer 200 is further used for impedance matching of a wave in space (for example, the RF signal in the preset frequency band). With aid of the coupling structure 300, the transmittance to the RF signal in the preset frequency band can be improved.

In another implementation manner, the housing assembly 10 includes the impedance matching layer 200, the coupling structure 300, and the dielectric substrate 100 that are sequentially stacked. The impedance matching layer 200 is used to encapsulate and protect the coupling structure 300, preventing the coupling structure 300 from being oxidized and corroded. The impedance matching layer 200 is further used for impedance matching of the RF signal in the preset frequency band. With aid of the coupling structure 300, the transmittance to the RF signal in the preset frequency band can be improved.

Referring to FIG. 3, the coupling structure 300 includes one array layer 310 and the array layer 310 is attached to one surface of the dielectric substrate 100, and the impedance matching layer 200 is disposed at one side of the array layer 310 away from the dielectric substrate 100 and is used to encapsulate and protect the array layer 310.

The array layer 310 is disposed at the bearing layer, to improve the transmittance to the RF signal in the preset frequency band. In an example, the array layer 310 has a single-layer structure. The array layer 310 can be connected to the bearing layer via a connecting member. The connecting member may be an adhesive. The array layer 310 has the resonance characteristics to the RF signal in the preset frequency band, which can enable the RF signal in the preset frequency band to resonate, thereby improving the transmittance to the RF signal in the preset frequency band.

In an implementation manner, the orthographic projection of the coupling structure 300 on the dielectric substrate 100 covers the entire dielectric substrate 100. In other words, the bearing layer covers the entire dielectric substrate 100, and the coupling structure 300 is carried on the bearing layer and is arranged corresponding to the entire dielectric substrate 100. As such, the entire housing assembly 10 has a high transmittance to the RF signal in the preset frequency band. In the implementation, the orthographic projection of the coupling structure 300 on the dielectric substrate 100 covers the entire dielectric substrate 100, which is beneficial to reducing the complexity of the manufacturing process of the housing assembly 10.

In another implementation manner, the orthographic projection of the coupling structure 300 on the dielectric substrate 100 partially covers the dielectric substrate 100. In the implementation, an area of the coupling structure 300 is smaller than an area of the dielectric substrate 100, and the coupling structure 300 is disposed corresponding to a part of the dielectric substrate 100. In this way, the housing assembly 10 has different transmittances to the RF signal in the preset frequency band in different regions of the housing assembly 10, which is beneficial for flexible setting of the transmittance of the housing assembly 10 to the RF signal in the preset frequency band.

Referring to FIG. 4, the coupling structure 300 includes one array layer 310. The impedance matching layer 200 includes a first matching layer 210 and a second matching layer 220. The first matching layer 210 is disposed at one surface of the dielectric substrate 100. The array layer 310 is disposed at one side of the first matching layer 210 away from the dielectric substrate 100. The first matching layer 210 is used to connect the array layer 310 to the dielectric substrate 100. The second matching layer 220 is disposed at one side of the array layer 310 away from the first matching layer 210 and is used to encapsulate and protect the array layer 310.

In the implementation, the housing assembly 10 includes the second matching layer 220, the array layer 310, the first matching layer 210, and the dielectric substrate 100 that are sequentially stacked. The first matching layer 210 and the second matching layer 220 cooperate with each other, to support, encapsulate, and protect the array layer 310. In addition, the first matching layer 210 and the second matching layer 220 cooperate with each other, for spatial impedance matching of the RF signal in the preset frequency band, to increase the bandwidth of the RF signal. Due to the array layer 310, for the RF signal, secondary resonance arises, to improve the transmittance of the dielectric substrate 100 to the RF signal.

Referring to FIG. 5, the coupling structure 300 includes a first array layer 310 and a second array layer 320 spaced apart from the first array layer 310. The impedance matching layer 200 includes a first matching layer 210 and a second matching layer 220. The first array layer 310 is disposed at one surface of the dielectric substrate 100. The first matching layer 210 is disposed at one side of the first array layer 310 away from the dielectric substrate 100. The first matching layer 210 is used to connect the first array layer 310 to the dielectric substrate 100 and is used to encapsulate and protect the first array layer 310. The second array layer 320 is disposed at one side of the first matching layer 210 away from the first array layer 310. The second matching layer 220 is disposed at one side of the second array layer 320 away from the first matching layer 210 and is used to encapsulate and protect the second array layer 320.

In the implementation, the housing assembly 10 includes the second matching layer 220, the second array layer 320, the first matching layer 210, the first array layer 310, and the dielectric substrate 100 that are sequentially stacked. The first matching layer 210 and the second matching layer 220 cooperate with each other, to support, encapsulate, and protect the second array layer 320 and the first array layer 310. In addition, the first matching layer 210 and the second matching layer 220 cooperate with each other, for spatial impedance matching of the RF signal in the preset frequency band, to increase the bandwidth of the RF signal. Due to the second array layer 320 and the first array layer 310, for the RF signal, secondary resonance arises, to improve the transmittance of the dielectric substrate 100 to the RF signal.

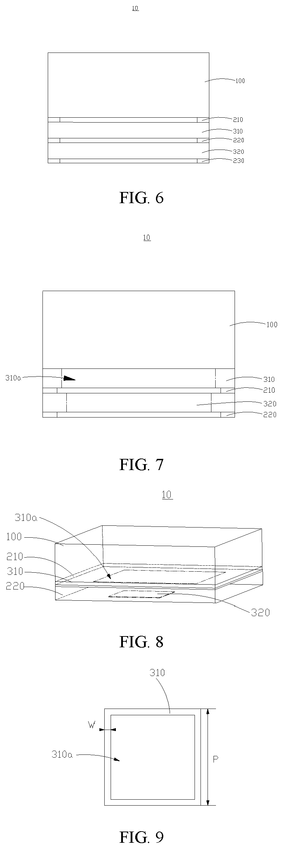

Referring to FIG. 6, the coupling structure 300 includes a first array layer 310 and a second array layer 320 spaced apart from the first array layer 310. The impedance matching layer 200 includes a first matching layer 210, a second matching layer 220, and a third matching layer 230. The first matching layer 210 is disposed at one surface of the dielectric substrate 100. The first array layer 310 is disposed at one surface of the first matching layer 210 away from the dielectric substrate 100. The second matching layer 220 is disposed at one side of the first array layer 310 away from the first matching layer 210. The second array layer 320 is disposed at one side of the second matching layer 220 away from the first array layer 310. The third matching layer 230 is disposed at one side of the second array layer 320 away from the second matching layer 220 and is used to encapsulate and protect the second array layer 320.

In the implementation, the housing assembly 10 includes the third matching layer 230, the second array layer 320, the second matching layer 220, the first array layer 310, the first matching layer 210, and the dielectric substrate 100 that are sequentially stacked. The first matching layer 210, the second matching layer 220, and the third matching layer 230 cooperate with one another, to support, encapsulate, and protect the second array layer 320 and the first array layer 310. In addition, the first matching layer 210, the second matching layer 220, and the third matching layer 230 cooperate with one another, for spatial impedance matching of the RF signal in the preset frequency band, to increase the bandwidth of the RF signal. Due to the second array layer 320 and the first array layer 310, for the RF signal, secondary resonance arises, to improve the transmittance of the dielectric substrate 100 to the RF signal.

In at least one implementation, the first array layer 310 and the second array layer 320 are each disposed at a respective one of two opposite sides of the second matching layer 220, and the first array layer 310 is closer to the dielectric substrate 100 than the second array layer 320.

The coupling structure 300 includes the first array layer 310 and the second array layer 320 spaced apart from each other. The first array layer 310 and the second array layer 320 are both disposed at the second matching layer 220, where the first array layer 310 and the second array layer 320 are each disposed at a respective one of two opposite sides of the second matching layer 220, and the first array layer 310 is closer to the dielectric substrate 100 than the second array layer 320.

In an example, the first array layer 310 is disposed between the dielectric substrate 100 and the second matching layer 220, and the second array layer 320 is disposed at one side of the second matching layer 220 away from the first array layer 310. At least one of the first array layer 310 and the second array layer 320 has resonance characteristics to the RF signal in the preset frequency band. In an example, the first array layer 310 has resonance characteristics to the RF signal in the preset frequency band, which can cause the RF signal in the preset frequency band to resonate, thereby improving the transmittance to the RF signal in the preset frequency band. In another example, the second array layer 320 has resonance characteristics to the RF signal in the preset frequency band, which can cause the RF signal in the preset frequency band to resonate, thereby improving the transmittance to the RF signal in the preset frequency band. In another example, both the first array layer 310 and the second array layer 320 have resonance characteristics to the RF signal in the preset frequency band, which can cause the RF signal in the preset frequency band to resonate, thereby improving the transmittance to the RF signal in the preset frequency band.

In at least one implementation, a projection of the first array layer 310 on the second matching layer 220 and a projection of the second array layer 320 on the second matching layer 220 are at least partially non-overlapping. In other words, the first array layer 310 can be completely misaligned with the second array layer 320 in a thickness direction. Alternatively, the first array layer 310 can be partially misaligned with the second array layer 320 in the thickness direction. As such, mutual interference caused by the resonance characteristics of the first array layer 310 and the second array layer 320 can be reduced, which can improve stability of the RF signal passing through the housing assembly 10.

Referring to FIG. 7, FIG. 8, FIG. 9, and FIG. 10, the first array layer 310 defines a through hole 310a and a projection of the second array layer 320 on the first array layer 310 falls into the through hole 310a.

In at least one implementation, the through hole 310a is in a shape of circle, oval, square, triangle, rectangle, hexagon, ring, cross, or Jerusalem cross.

In at least one implementation, the first matching layer 210 is an adhesive, the second matching layer 220 is a bearing layer, and the third matching layer 230 is an adhesive. In at least one implementation, the first array layer 310 is a square patch and has a side length P of 1.6 mm. The second array layer 320 is a square patch and has a side length L of 1.05 mm. The through hole 310a is a square hole, where W=0.15 mm, and has a size of 1.3 mm×1.3 mm. The dielectric substrate 100 has a thickness of 0.55 mm, the first matching layer 210 has a thickness of 0.02 mm, the second matching layer 220 has a thickness of 0.45 mm, and the third matching layer 230 has a thickness of 0.03 mm.

In the implementation, the first array layer 310 defines the through hole 310a. The size of the through hole 310a can be greater than the size of the perimeter of the second array layer 320. The projection of the second array layer 320 on the first array layer 310 may fall within the through hole 310a. The RF signal in the preset frequency band can be transmitted through the through hole 310a of the first array layer 310 after being subjected to the resonance effect of the second array layer 320, thereby reducing interference of the first array layer 310 on the RF signal after being subjected to the resonance effect of the second array layer 320. In this way, stability of the RF signal transmission can be achieved. Further, the first array layer 310 and the second array layer 320 together are used for spatial impedance matching of the RF signal in the preset frequency band, such that the frequency of the RF signal can be adjusted.

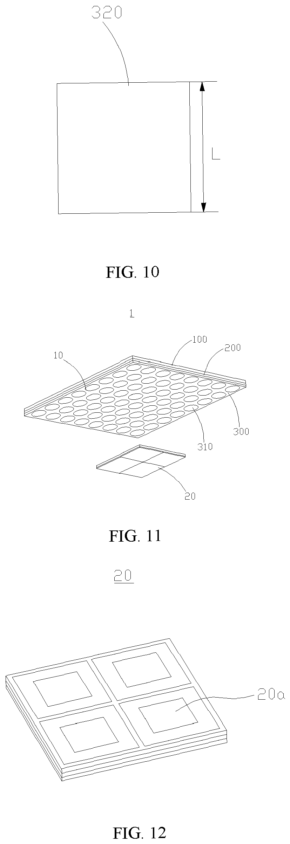

Referring to FIG. 11 and FIG. 12, an antenna device 1 is provided in implementations of this application. The antenna device 1 includes an antenna module 20 and the housing assembly 10 of any of the above implementations. The antenna module 20 is spaced apart from the coupling structure 300 and is disposed at one side of the coupling structure 300 away from the dielectric substrate 100. The coupling structure 300 is at least partially located within a preset direction range in which the antenna module 20 emits and receives an RF signal. The coupling structure 300 is used to match a frequency of the RF signal, to improve a transmittance to the RF signal. The impedance matching layer 200 is used for spatial impedance matching of the RF signal, to increase a bandwidth of the RF signal.

In the implementation, the antenna module 20 is spaced parted from the coupling structure 300. The antenna module 20 is located on one side of the coupling structure 300 away from the dielectric substrate 100. The antenna module 20 may include one antenna radiator 20a. Alternatively, the antenna radiator 20a may be an antenna array including multiple antenna radiators 20a. The antenna module 20 can be a 2×2 antenna array, a 2×4 antenna array, or a 4×4 antenna array. In a case that the antenna module 20 includes multiple antenna radiators 20a, the multiple antenna radiators 20a can work in the same frequency band. The multiple antenna radiator 20a can also work in different frequency bands, which helps to expand the frequency range of antenna module 20.

Furthermore, the coupling structure 300 is at least partially located within the preset direction range for emitting and receiving the RF signal by the antenna radiator 20a, so that for the RF signal emitted and received by the antenna radiator 20a, secondary resonance arises. In a case that the coupling structure 300 is located within the preset direction range for emitting and receiving the RF signal by the antenna radiator 20a, the resonance characteristics of the coupling structure 300 can enable the RF signal to have resonance characteristics. As such, the transmittance to the RF signal emitted and received by the antenna radiator 20a can be improved. In other words, the coupling structure 300 enables the radiation efficiency in a corresponding frequency band of the antenna radiator 20a to be improved.

Furthermore, the antenna radiator 20a is disposed at one side of the coupling structure 300 away from the dielectric substrate 100. The RF signal after frequency matching by the coupling structure 300 is capable of penetrating the dielectric substrate 100 to radiate in a direction away from the antenna radiator 100. The impedance matching layer 200 is used for spatial impedance matching of the RF signal emitted and received by the antenna module 20, to increase the bandwidth of the RF signal.

In the implementation, once the RF signal generated by the antenna radiator 20a reaches a surface of the coupling structure 300, due to the resonance characteristics of the coupling structure 300, secondary resonance arises, thereby improving the transmittance to the RF signal. In this way, the dielectric substrate 100 can have an improved transmittance to the RF signal. With such structural arrangement, the radiation gain of the antenna radiator 20a can be improved, and the performance of the antenna radiator 20a can be enhanced. The coupling structure 300 and the impedance matching layer 200 cooperate with each other, where the impedance matching layer 200 is used to increase the bandwidth of the RF signal and the coupling structure 300 is used to improve the transmittance to the RF signal, so that the RF signal exhibits dual-frequency dual-polarization characteristics.

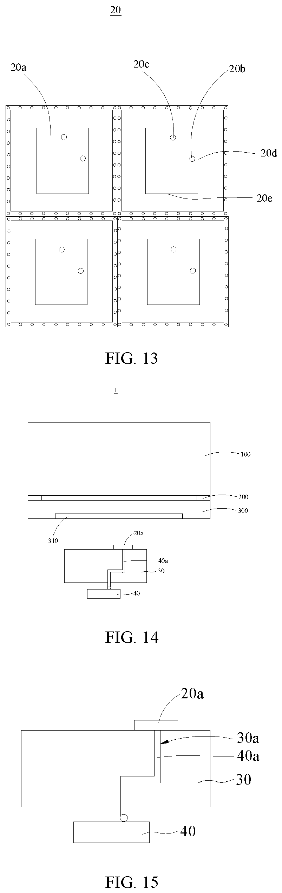

Referring to FIG. 13, the antenna module 20 includes multiple antenna radiators 20a arranged in an array. The antenna radiator 20a has a first feed point 20b and a second feed point 20c. The first feed point 20b is configured to feed a first current signal to the antenna radiator 20a and the first current signal is used to excite the antenna radiator 20a to resonate in a first frequency band to emit and receive an RF signal in the first frequency band. The second feed point 20c is configured to feed a second current signal to the antenna radiator 20a and the second current signal is used to excite the antenna radiator 20a to resonate in a second frequency band, where the first frequency band is different from the second frequency band.

In at least one implementation, a polarization direction of a resonance mode of the antenna radiator 20a excited by the first current signal is different from a polarization direction of a resonance mode of the antenna radiator 20a excited by the second current signal.

The first frequency band can be a high-frequency signal and the second frequency band can be a low-frequency signal. Alternatively, the first frequency band can be a low-frequency signal and the second frequency band can be a high-frequency signal.

According to the specification of the 3GPP TS 38.101, two frequency ranges are mainly used in 5G: FR1 and FR2. The frequency range corresponding to FR1 is 450 MHz~6 GHz, also known as the sub-6 GHz; the frequency range corresponding to FR2 is 24.25 GHz~52.6 GHz, usually called millimeter wave (mm Wave). Currently, 3GPP (version 15) specifies the frequency bands of the 5G millimeter wave as follows: n257 (26.5∼29.5 GHz), n258 (24.25∼27.5 GHz), n261 (27.5∼28.35 GHz), and n260 (37∼40 GHz). The first frequency band can be n257, and meanwhile the second frequency band can be n258, n260, or n261.

The antenna radiator 20a may be a rectangular patch antenna with a long side 20d and a short side 20e. The first feed point 20b is disposed at the long side 20d of the antenna radiator 20a, configured to emit and receive the RF signal in the first frequency band. The RF signal in the first frequency band is a low-frequency signal. The second feed point 20c is disposed at the short side 20e of the antenna radiator 20a, configured to emit and receive the RF signal in the second frequency band. The RF signal in the second frequency band is a high-frequency signal. The long side 20d and short side 20e of the antenna radiator 20a are used to change an electrical length of the antenna radiator 20a, thereby changing the frequency of the RF signal emitted by the antenna radiator 20a.

Referring FIG. 14, the antenna device 1 further includes a support plate 30, an RF chip 40, and an RF line 40a, where the antenna radiator 20a is disposed on a surface of the support plate 30 adjacent to the coupling structure 300, the RF chip 40 is disposed at one side of the support plate 30 away from the coupling structure 300, and the RF line 40a electrically couples the RF chip 40 with the antenna radiator 20a.

The support plate 30 can be prepared by performing a high density inverter (HDI) process on a multilayer printed circuit board (PCB). The RF chip 40 is located at one side of the support plate 30 away from the antenna radiator 20a. The antenna radiator 20a has at least one feed point which is used to receive an RF signal from the RF chip 40, such that RF signals in different frequency bands can be generated.

Additionally, positioning the antenna radiator 20a on the surface of the support plate 30 close to the coupling structure 300 can make the RF signal generated by the antenna radiator 20a transmit towards the coupling structure 300. Because the coupling structure 300 has the resonance characteristics, the RF signal has stronger penetrability after being subjected to the resonance effect of the coupling structure 300, which can enhance the radiation gain of the antenna radiator 20a. Moreover, the RF chip 40 is disposed at one side of the support plate 30 away from the coupling structure 300, which can reduce unnecessary interference of the RF chip 40 on the coupling structure 300, thereby facilitating stable resonance characteristics of the coupling structure 300 and stable radiation characteristics of the antenna radiator 20a.

Referring to FIG. 15, the support plate 30 defines a limiting hole 30a and the RF line is 40a located in the limiting hole 30a. The RF line 40a can have one end electrically connected with the antenna radiator 20a and the other end electrically connected with the RF chip 40. The RF signal generated by the RF chip 40 is emitted to the antenna radiator 20a via the RF line 40a.

In order to electrically connect the RF chip 40 and the antenna radiator 20a, the support plate 30 needs to define the limiting hole 30a. The RF line 40a is disposed in the limiting hole 30a, to electrically connect the antenna radiator 20a and the RF chip 40. As such, the RF signal generated at the RF chip 40 is emitted to the antenna radiator 20a, and then the antenna radiator 20a generates the RF signal according to the RF signal.

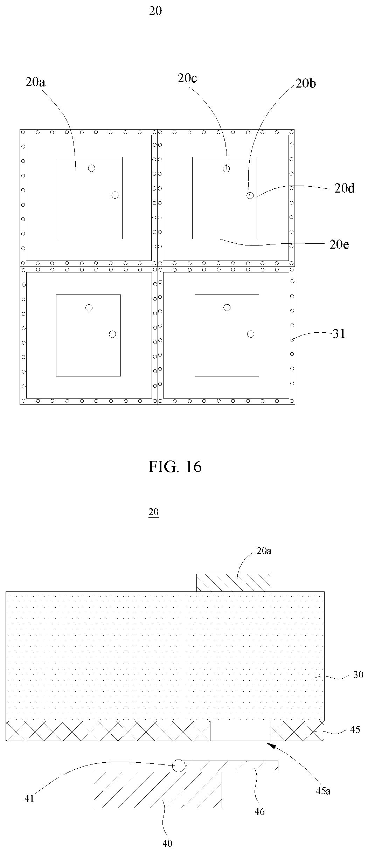

Referring to FIG. 16, the support plate 30 defines multiple metallized vias 31 arranged around the antenna radiator 20a to isolate two adjacent antenna radiators 20a.

In the implementation, there are several uniformly arranged metallized vias 31 on the support plate 30, which surround the antenna radiator 20a. The metallized vias 31 can be provided to achieve isolation and decoupling in the antenna module 20. That is, due to the presence of the metallized vias 31, radiation interference between adjacent two antenna radiators 200 due to mutual coupling can be prevented, and the antenna radiator 20a can be ensured to be in a stable working state.

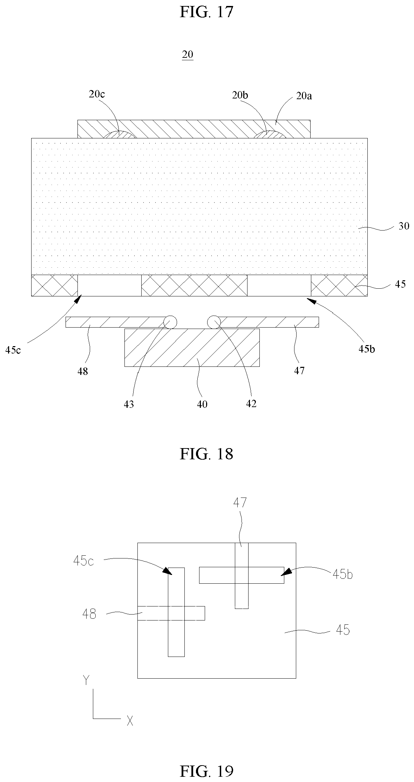

Referring to FIG. 17, the antenna device 1 further includes a feed ground layer 45. The antenna radiator 20a is disposed on a surface of the support plate 30 adjacent to the coupling structure 300 and the RF chip 40 is disposed at one side of the support plate 30 away from the coupling structure 300. The feed ground layer 45 is located between the support plate 30 and the RF chip 40 and serves as a ground electrode of the antenna radiator 20a. The feed line 46 is disposed between the RF chip 40 and the feed ground layer 45 and is electrically coupled to the RF chip 40. The feed ground layer 45 defines an aperture 45a, a projection of the feed line 46 on the feed ground layer 45 at least partially falls into the aperture 45a, and the feed line 46 is configured to couple and feed the antenna radiator 20a via the aperture 45a.

The RF chip 40 has an output end 41, where the output end 41 can be used to generate an RF signal. The RF signal generated by the RF chip 40 is emitted to the feed line 46. The feed line 46 is disposed corresponding to the aperture 45a of the feed ground layer 45. Thus, the feed line 46 can transmit, via the aperture 45a, the RF signal received to the feed point of the antenna radiator 20a through coupling. The antenna radiator 20a is coupled to the RF signal from the feed line 46 to generate the RF signal in the preset frequency band.

Furthermore, the feed ground layer 45 serves as the ground electrode of the antenna radiator 20a. The antenna radiator 20a does not need to be electrically connected with the feed ground layer 45 directly, but the antenna radiator 20a is grounded by coupling. The projection of the feed line 46 on the feed ground layer 45 is at least partially within the aperture 45a, so that the feed line 46 can conduct coupling feed on the antenna radiator 20a via the aperture 45a.

Referring to FIG. 18, in other examples, the RF chip 40 has a first output end 42 and a second output end 43. The first output end 42 is used to generate a first RF signal. The second output end 43 is used to generate a second RF signal. The first RF signal generated by the RF chip 40 is emitted to a first sub-feed line 47. The first sub-feed line 47 is disposed corresponding to a first aperture 45b of the feed ground layer 45. Thus, the first sub-feed line 47 can transmit, via the first aperture 45b, the first RF signal received to a first sub-feed point 20b of the antenna radiator 20a in a coupling manner. The antenna radiator 20a is coupled to the first RF signal from the first sub-feed line 47 to generate an RF signal in a first frequency band. The second sub-feed line 48 is disposed corresponding to a second aperture 45c of the feed ground layer 45. Thus, the second sub-feed line 48 can transmit, via the second aperture 45c, the second RF signal received to a second sub-feed point 20c of the antenna radiator 20a in a coupling manner. The antenna radiator 20a is coupled to the second RF signal from the second sub-feed line 48 to generate an RF signal in a second frequency band. When the first RF signal is different from the second RF signal, the antenna module 20 can work in multiple frequency bands, widening the frequency range of the antenna module 20. In this way, the use range of the antenna module 20 can be adjusted flexibly.

Furthermore, the feed ground layer 45 serves as the ground electrode of the antenna radiator 20a. The antenna radiator 20a and the feed ground layer 45 do not need to be electrically connected directly, but the antenna radiator 20a is grounded by coupling. The projection of the first sub-feed line 47 on the feed ground layer 45 is at least partially within the first aperture 45b, and the projection of the second sub-feed line 48 on the feed ground layer 45 is at least partially within the second aperture 45c. It is convenient for the first sub-feed line 47 to conduct coupling feed on the antenna radiator 20a via the first aperture 45b and for the second sub-feed line 48 to conduct coupling feed on the antenna radiator 20a via the second aperture 45c.

Referring to FIG. 19, the first aperture 45b extends in a first direction and the second aperture 45c extends in a second direction, where the first direction is perpendicular to the second direction.

In an example, both the first aperture 45b and the second aperture 45c can be strip slots. The first aperture 45b can be a vertical polarized slot or a horizontal polarized slot. The second aperture 45c can be a vertical polarized slot or a horizontal polarized slot. When the first aperture 45b is a vertical polarized slot, the second aperture 45c is a horizontal polarized slot. When the first aperture 45b is a horizontal polarized slot, the second aperture 45c is a vertical polarized slot. An example in which an extending direction of the first aperture 45b is the Y direction and an extending direction of the second aperture 45c is the X direction is taken in this application. When the extending direction of the first aperture 45b is perpendicular to the extending direction of the second aperture 45c, the feed ground layer 45 is a feed ground layer with a bipolar (or a dual-polarized) aperture 45a. In this case, the antenna module 20 is a dual-polarized antenna module. Thus, the radiation direction of the antenna module 20 can be adjusted, which in turn can achieve targeted radiation, increasing the gain of radiation of the antenna module 20. The "polarization of the antenna" may refers to a direction of the electric field strength in which the antenna radiates an electromagnetic wave.

Furthermore, the extending direction of the first aperture 45b is perpendicular to an extending direction of the first sub-feed line 47, and the extending direction of the second aperture 45c is perpendicular to an extending direction of the second sub-feed line 48.

The first aperture 45b and the second aperture 45c are both strip shots. The first sub-feed line 47 is spaced apart from the feed ground layer 45. The second sub-feed line 48 is spaced apart from the feed ground layer 45. The projection of the first sub-feed line 47 on the feed ground layer 45 is at least partially within the first aperture 45b. The projection of the second sub-feed line 48 on the feed ground layer 45 is at least partially within the second aperture 45c. The extending direction of the first sub-feed line 47 is perpendicular to the extending direction of the first aperture 45b, and the extending direction of the second sub-feed line 48 is perpendicular to the extending direction of the second aperture 45c. In this way, the coupling feed effect of the dual-polarized antenna module 20 can be improved, thereby improving the radiation efficiency of the antenna module 20 and improving the radiation gain.

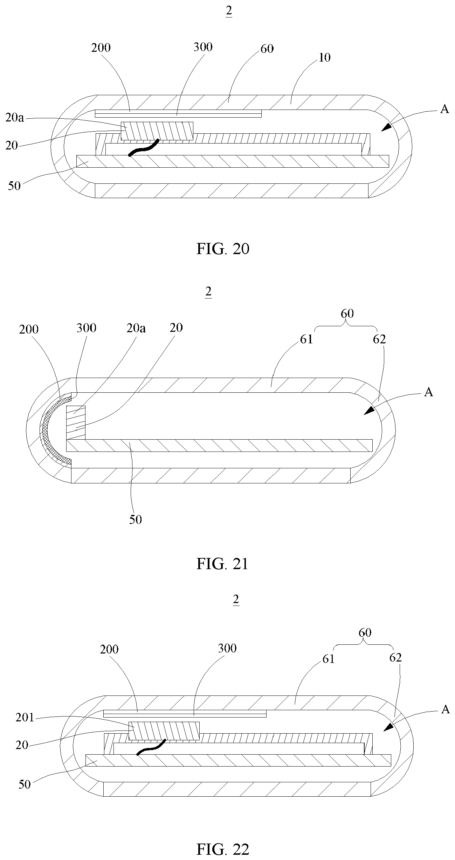

Referring to FIG. 20, an electronic device 2 is provided in implementations of this application. The electronic device 2 includes a mainboard 50, an antenna module 20, and the housing assembly 10 of any of the above implementations. The mainboard 50 is received in the housing assembly 10. The mainboard 50 defines an accommodating space A at one side of the housing assembly 10 facing the coupling structure 300. The antenna module 20 is received in the accommodating space A and electrically coupled to the mainboard 50. The antenna module 20 includes at least one antenna radiator 20a. The antenna radiator 20a is configured to, under control of the mainboard 50, emit and receive RF signals which pass through the housing assembly 10.

The electronic device 2 can be any device with communication and storage functions, for example, tablet computers, mobile phones, e-readers, remote controllers, personal computers (PC), notebook computers, in-vehicle devices, network TVs, wearable devices, and other smart devices with network functions.

The mainboard 50 can be a PCB of the electronic device 2. The mainboard 50 and the housing assembly 10 cooperate to define the accommodating space A. The antenna module 20 is received in the accommodating space A and the antenna module 20 is electrically connected with the mainboard 50. The antenna module 20 may include one or more antenna radiators 20a. Alternatively, the antenna module 20 may be an antenna array including multiple antenna radiators 20a. Under the control of the mainboard 50, the antenna radiator 20a can emit and receive an RF signal through the housing assembly 10. Because the coupling structure 300 has resonance characteristics, the RF signal can have resonance characteristics, to enhance the penetrability of the RF signal. As such, the transmittance to the RF signal can be higher when the RF signal passes through the housing assembly 10.

The electronic device 2 further includes a battery cover 60. In this case, the battery cover 60 acts as the dielectric substrate 100. The battery cover 60 can be made of any one or more of plastic, glass, sapphire, and ceramic.

In detail, in the structural arrangement of the electronic device 2, at least a part of the battery cover 60 is located within a preset direction range of emitting/receiving an RF signal by the antenna radiator 20a. Therefore, the battery cover 60 will also affect the radiation characteristics of the antenna radiator 20a. As such, in the implementation, using the battery cover 60 as the dielectric substrate 100 can make the antenna radiator 20a have stable radiation performance in the structural arrangement of the electronic device 2. At this case, the battery cover 60 can be made of a wave-transparent material. The battery cover 60 can be made of any one of more of plastic, glass, sapphire, and ceramic.

Referring to FIG. 21, the battery cover 60 includes a rear plate 61 and a side plate 62 surrounding the rear plate 61. When the side plate 62 is located in a preset direction range in which the antenna radiator 20a emits and receives RF signals. The coupling structure 300 is disposed at one side of the side plate 62 facing the antenna radiator 20a. In this case, the side plate 62 acts as the dielectric substrate 100.

In detail, when the antenna radiator 20a faces the side plate 62 of the battery cover 60, the side plate 62 can be used for spatial impedance matching of the RF signal emitted/received by the antenna module 20. In this case, the side plate 62 acts as the dielectric substrate 100. The coupling structure 300 is disposed at the side of the side plate 62 facing the antenna radiator 20a. The coupling structure 300 has resonance characteristics to the RF signal in the preset frequency band, which can cause the RF signal to have resonance characteristics. In this way, the RF signal emitted/received by the antenna radiator 20a can pass through the side plate 62. The side plate 62 can act as the dielectric substrate 100 for spatial impedance matching of the antenna radiator 20a, as such, the arrangement of the antenna radiator 20a in the entire electronic device 2 is taken into consideration. In this way, the radiation effect of the antenna radiator 20a in the entire electronic device can be ensured.

Referring to FIG. 22, the battery cover 60 includes a rear plate 61 and a side plate 62 surrounding the rear plate 61. The rear plate 61 is located within a preset direction range in which the antenna radiator 20a emits and receives RF signals. The coupling structure 300 is disposed at one side of the rear plate 61 facing the antenna radiator 20a. In this case, the rear plate 61 acts as the dielectric substrate 100.

In detail, when the antenna radiator 20a faces the rear plate 61 of the battery cover 60, the rear plate 61 can be used for spatial impedance matching of the RF signal emitted/received by the antenna radiator 20a. In this case, the rear plate 61 acts as the dielectric substrate 100. The coupling structure 300 is disposed at the side of the rear plate 61 facing the antenna radiator 20a. The coupling structure 300 has resonance characteristics to the RF signal in the preset frequency band, which can cause the RF signal to have resonance characteristics. In this way, the RF signal emitted/received by the antenna radiator 20a can pass through the rear plate 61. The rear plate 61 can act as the dielectric substrate 100 for spatial impedance matching of the antenna radiator 20a, as such, the arrangement of the antenna radiator 20a in the entire electronic device 2 is taken into consideration. In this way, the radiation effect of the antenna radiator 20a in the entire electronic device can be ensured.

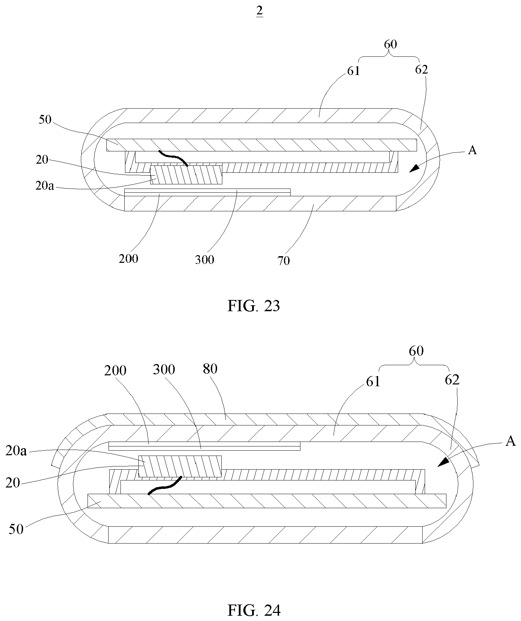

Referring to FIG. 23, the electronic device 2 further includes a screen 70 and the screen 70 acts as the dielectric substrate 100.

In detail, when the antenna radiator 20a faces the screen 70, the screen 70 can be used for spatial impedance matching of the RF signal emitted/received by the antenna radiator 20a. In this case, the screen 70 acts as the dielectric substrate 100. The coupling structure 300 is disposed at one side of the screen 70 facing the antenna radiator 20a. The coupling structure 300 has resonance characteristics to the RF signal in the preset frequency band, which can cause the RF signal to have resonance characteristics. In this way, the RF signal emitted/received by the antenna radiator 20a can pass through the screen 70 for transmission. The screen 70 can act as the dielectric substrate 100 for spatial impedance matching of the antenna radiator 20a, as such, the arrangement of the antenna radiator 20a in the entire electronic device 2 is taken into consideration. In this way, the radiation effect of the antenna radiator 20a in the entire electronic device can be ensured.

Referring to FIG. 24, the electronic device 2 further includes a protective cover 80. The protective cover 80 can be located within the preset direction range in which the antenna radiator 20a emits and receives RF signals. In this case, the protective cover 80 acts as the dielectric substrate 100.

In detail, when the antenna radiator 20a faces the protective cover 80, the protective cover 80 can be used for spatial impedance matching of the RF signal emitted/received by the antenna radiator 20a. In this case, the protective cover 80 acts as the dielectric substrate 100. The coupling structure 300 is disposed at one side of the protective cover 80 facing the antenna radiator 20a. The coupling structure 300 has resonance characteristics to the RF signal in the preset frequency band, which can cause the RF signal to have resonance characteristics. In this way, the RF signal emitted/received by the antenna radiator 20a can pass through the protective cover 80 for transmission. The protective cover 80 can act as the dielectric substrate 100 for spatial impedance matching of the antenna radiator 20a. As such, the arrangement of the antenna radiator 20a in the entire electronic device 2 is taken into consideration. In this way, the radiation effect of the antenna radiator 20a in the entire electronic device can be ensured.

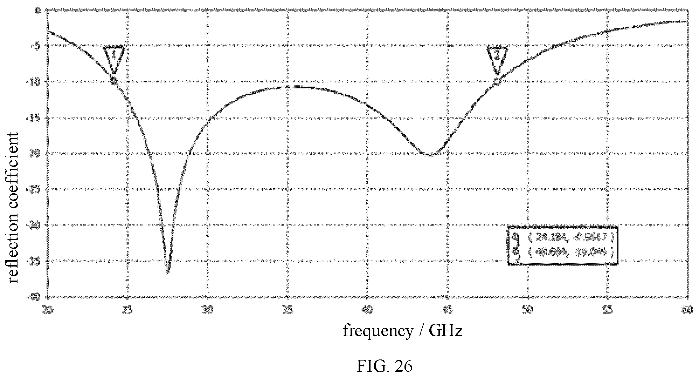

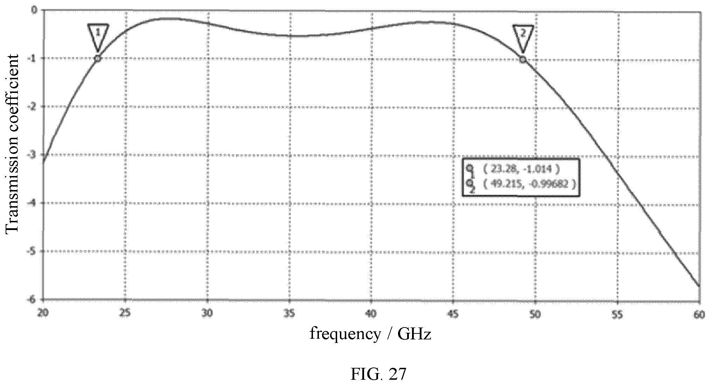

Referring to FIG. 25, FIG. 26, and FIG. 27, FIG. 25 is a schematic diagram of curves of a reflection coefficient and a transmission coefficient of a 2×2 antenna module in free space. FIG. 26 is a schematic diagram of a curve of a reflection coefficient of a 2×2 antenna module under a housing assembly. FIG. 27 is a schematic diagram of a curve of a transmission coefficient of a 2×2 antenna module under a housing assembly.

The dielectric constant of the glass battery cover is Dk=6.8, Df=0.02, and the thickness of the glass battery cover is 0.7 mm. According to the reflection/transmission coefficient of the glass battery cover of the thickness of 0.7 mm at 20~50GHz, at the interface between the air and the glass battery cover, the reflection coefficient S11 is large and the transmission coefficient S21 is small, where less than half of the energy passes through.

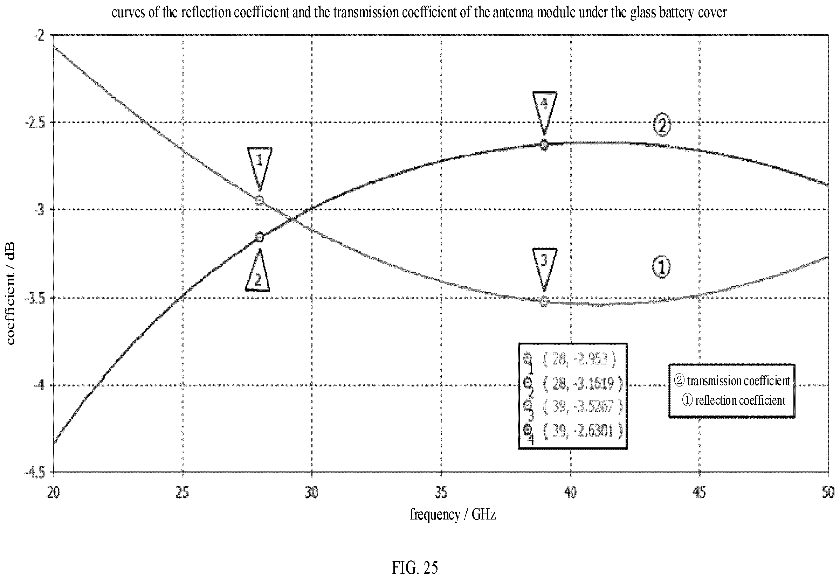

Furthermore, referring to FIG. 25, Curve ① is the curve of the reflection coefficient of the antenna module under the glass battery cover. Curve ② is the curve of the transmission coefficient of the antenna module under the glass battery cover. For curve ①, at mark 1, a corresponding frequency is 28 GHz and a corresponding reflection coefficient is -2.953; at mark 3, a corresponding frequency is 39 GHz and a corresponding reflection coefficient is -3.5267. For curve ②, at mark 2, a corresponding frequency is 28 GHz and a corresponding reflection coefficient is -3.1619; at mark 4, a corresponding frequency is 39 GHz and a corresponding reflection coefficient is -2.6301.

Furthermore, referring to FIG. 26, the curve is the curve of the reflection coefficient of the antenna module under the housing assembly. For the curve, at mark 1, a corresponding frequency is 24.184 GHz and a corresponding reflection coefficient is -9.9617; at mark 2, a corresponding frequency is 48.089 GHz and a corresponding reflection coefficient is -10.049.

Furthermore, referring to FIG. 27, the curve is the curve of the transmission coefficient of the antenna module under the housing assembly. For the curve, at mark 1, a corresponding frequency is 23.28 GHz and a corresponding transmission coefficient is -1.014; at mark 2, a corresponding frequency is 49.215 GHz and a corresponding transmission coefficient is -0.99682.

Referring to FIG. 26 and FIG. 27, for a plane wave passing through the housing assembly, the reflection coefficient Sllat 24.1~48GHz satisfies S11≤-10dB, which can fully cover the all frequency bands of 3GPP. Compared with the "conventional battery cover" which has a large reflection coefficient, this ultra-wideband radio-wave transparent battery cover has less impact on the millimeter wave antenna. In terms of transmission, at 23.2~49.2GHz, the plane electromagnetic wave has only 1 dB of energy loss when passing through the "radio-wave transparent battery cover". The concept of "ultra-wideband dual-frequency dual-polarization frequency selective surface" is introduced into the millimeter wave antenna of the mobile phone, and the dual-frequency dual-polarization metal structure is integrated in the battery cover. This makes the battery cover exhibit high transmission characteristics for the all frequency bands (n257, n258, n261, n259, n260) of 3GPP, forming a "millimeter wave ultra-wideband dual-frequency dual-polarization radio-wave transparent battery cover" with a relative bandwidth of 66%, thereby alleviating coverage effect of the battery cover to the millimeter wave antenna module.

The implementations of this application are described in detail above, specific examples are used herein to describe the principle and implementation manners of this application. The description of the above implementations is merely used to help understand the method and the core idea of this application. Meanwhile, those skilled in the art may make modifications to the specific implementation manners and the application scope according to the idea of this application. In summary, the contents of the specification should not be construed as limiting this application.

## Claims

1. A housing assembly, comprising:
a dielectric substrate having a first transmittance to a radio frequency (RF) signal in a preset frequency band;
an impedance matching layer stacked with the dielectric substrate and used for spatial impedance matching of the RF signal in the preset frequency band; and
a coupling structure stacked with the dielectric substrate and comprising one or more array layers of coupling elements, the array layer having resonance characteristics in the preset frequency band;
wherein the housing assembly has a second transmittance to the RF signal in the preset frequency band in a region corresponding to the coupling structure, and the second transmittance is greater than the first transmittance.

2. The housing assembly of claim 1, wherein
the impedance matching layer is disposed at one side of the dielectric substrate and the coupling structure is disposed at one side of the impedance matching layer away from the dielectric substrate; or
the coupling structure is disposed at one side of the dielectric substrate and the impedance matching layer is disposed at one side of the coupling structure away from the dielectric substrate.

3. The housing assembly of claim 1, wherein the array layer further has dual-polarization resonance characteristics in the preset frequency band.

4. The housing assembly of claim 1, wherein
the coupling structure comprises one array layer and the array layer is attached to one surface of the dielectric substrate; and
the impedance matching layer is disposed at one side of the array layer away from the dielectric substrate and is used to encapsulate and protect the array layer.

5. The housing assembly of claim 1, wherein
the coupling structure comprises one array layer;
the impedance matching layer comprises a first matching layer and a second matching layer;
the first matching layer is disposed at one surface of the dielectric substrate;
the array layer is disposed at one side of the first matching layer away from the dielectric substrate;
the first matching layer is used to connect the array layer to the dielectric substrate; and
the second matching layer is disposed at one side of the array layer away from the first matching layer and is used to encapsulate and protect the array layer.

6. The housing assembly of claim 1, wherein
the coupling structure comprises a first array layer and a second array layer spaced apart from the first array layer;
the impedance matching layer comprises a first matching layer and a second matching layer;
the first array layer is disposed at one surface of the dielectric substrate;
the first matching layer is disposed at one side of the first array layer away from the dielectric substrate;
the first matching layer is used to connect the first array layer to the dielectric substrate and is used to encapsulate and protect the first array layer;
the second array layer is disposed at one side of the first matching layer away from the first array layer; and
the second matching layer is disposed at one side of the second array layer away from the first matching layer and is used to encapsulate and protect the second array layer.

7. The housing assembly of claim 1, wherein
the coupling structure comprises a first array layer and a second array layer spaced apart from the first array layer;
the impedance matching layer comprises a first matching layer, a second matching layer, and a third matching layer;
the first matching layer is disposed at one surface of the dielectric substrate;
the first array layer is disposed at one surface of the first matching layer away from the dielectric substrate;
the second matching layer is disposed at one side of the first array layer away from the first matching layer;
the second array layer is disposed at one side of the second matching layer away from the first array layer; and
the third matching layer is disposed at one side of the second array layer away from the second matching layer and is used to encapsulate and protect the second array layer.

8. The housing assembly of claim 7, wherein the first array layer and the second array layer are each disposed at a respective one of two opposite sides of the second matching layer, and the first array layer is closer to the dielectric substrate than the second array layer.

9. The housing assembly of claim 8, wherein a projection of the first array layer on the second matching layer and a projection of the second array layer on the second matching layer are at least partially non-overlapping.

10. The housing assembly of claim 9, wherein the first array layer defines a through hole and a projection of the second array layer on the first array layer falls into the through hole.

11. The housing assembly of claim 10, wherein the through hole is in a shape of circle, oval, square, triangle, rectangle, hexagon, ring, cross, or Jerusalem cross.

12. The housing assembly of claim 7, wherein the first matching layer is an adhesive, the second matching layer is a bearing layer, and the third matching layer is an adhesive.

13. The housing assembly of claim 10, wherein
the first array layer is a square patch and has a side length of 1.6 mm;
the second array layer is a square patch and has a side length of 1.05 mm;
the through hole is a square hole and has a size of 1.3 mm×1.3 mm; and
the dielectric substrate has a thickness of 0.55 mm, the first matching layer has a thickness of 0.02 mm, the second matching layer has a thickness of 0.45 mm, and the third matching layer has a thickness of 0.03 mm.

14. The housing assembly of any of claims 1-13, wherein the array layer comprises a plurality of coupling elements arranged in an array, wherein the plurality of coupling elements are made of conductive materials and have dual-frequency dual-polarization resonance characteristics in the preset frequency band.

15. The housing assembly of any of claims 1-13, wherein the preset frequency band at least comprises all frequency bands of millimeter wave of the 3rd generation partnership project (3GPP).

16. An antenna device, comprising an antenna module and the housing assembly of any of claims 1-15, wherein
the antenna module is spaced apart from the coupling structure and is disposed at one side of the coupling structure away from the dielectric substrate;
the coupling structure is at least partially located within a preset direction range in which the antenna module emits and receives a radio frequency (RF) signal;
the coupling structure is used to match a frequency of the RF signal, to improve a transmittance to the RF signal; and
the impedance matching layer is used for spatial impedance matching of the RF signal, to increase a bandwidth of the RF signal.

17. The antenna device of claim 16, wherein
the antenna module comprises a plurality of antenna radiators arranged in an array;
the antenna radiator has a first feed point and a second feed point;
the first feed point is configured to feed a first current signal to the antenna radiator and the first current signal is used to excite the antenna radiator to resonate in a first frequency band to emit and receive an RF signal in the first frequency band; and
the second feed point is configured to feed a second current signal to the antenna radiator and the second current signal is used to excite the antenna radiator to resonate in a second frequency band, wherein the first frequency band is different from the second frequency band.

18. The antenna device of claim 17, further comprising a support plate, an RF chip, and an RF line, wherein the antenna radiator is disposed on a surface of the support plate adjacent to the coupling structure, the RF chip is disposed at one side of the support plate away from the coupling structure, and the RF line electrically couples the RF chip with the antenna radiator.

19. The antenna device of claim 18, wherein the support plate defines a limiting hole and the RF line is located in the limiting hole.

20. The antenna device of claim 18, wherein the support plate defines a plurality of metallized vias arranged around the antenna radiator to isolate two adjacent antenna radiators.

21. The antenna device of claim 17, further comprising a support plate, an RF chip, a feed ground layer, and a feed line, wherein
the antenna radiator is disposed on a surface of the support plate adjacent to the coupling structure and the RF chip is disposed at one side of the support plate away from the coupling structure;
the feed ground layer is located between the support plate and the RF chip and serves as a ground electrode of the antenna radiator;
the feed line is disposed between the RF chip and the feed ground layer and is electrically coupled to the RF chip; and
the feed ground layer defines an aperture, a projection of the feed line on the feed ground layer at least partially falls into the aperture, and the feed line is configured to couple and feed the antenna radiator via the aperture.

22. The antenna device of any of claims 17-21, wherein a polarization direction of a resonance mode of the antenna radiator excited by the first current signal is different from a polarization direction of a resonance mode of the antenna radiator excited by the second current signal.

23. An electronic device, comprising a mainboard, an antenna module, and the housing assembly of any of claims 1-15, wherein
the mainboard is received in the housing assembly;
the mainboard defines an accommodating space at one side of the housing assembly facing the coupling structure and the antenna module is received in the accommodating space and electrically coupled to the mainboard; and
the antenna module comprises at least one antenna radiator and the antenna radiator is configured to, under control of the mainboard, emit and receive radio frequency (RF) signals which pass through the housing assembly.

24. The electronic device of claim 23, further comprising a battery cover, wherein the battery cover acts as the dielectric substrate and is made of one or more of plastic, glass, sapphire, and ceramic.

25. The electronic device of claim 24, wherein the battery cover comprises a rear plate and a side plate surrounding the rear plate, the side plate is located within a preset direction range in which the antenna radiator emits and receives RF signals, the coupling structure is disposed at one side of the side plate facing the antenna radiator, and the side plate acts as the dielectric substrate.

26. The electronic device of claim 24, wherein the battery cover comprises a rear plate and a side plate surrounding the rear plate, the rear plate is located within a preset direction range in which the antenna radiator emits and receives RF signals, the coupling structure is disposed at one side of the rear plate facing the antenna radiator, and the rear plate acts as the dielectric substrate.

27. The electronic device of claim 23, further comprising a screen, wherein the screen acts as the dielectric substrate.

28. The electronic device of claim 23, further comprising a protective cover, wherein the protective cover is located within a preset direction range in which the antenna radiator emits and receives RF signals and the protective cover acts as the dielectric substrate.
